# EUROPEAN PATENT SPECIFICATION

(11) **EP 0 653 069 B1**
(45) Date of publication and mention of the grant of the patent: **23.04.1997**
(21) Application number: 93916068.5
(22) Date of filing: 14.07.1993
(51) Int. Cl.: G01R 1/067

(54) **MOISTURE SENSING METHOD AND APPARATUS**
APPARAT UND VERFAHREN ZUM MESSEN VON FEUCHTIGKEIT
PROCEDE ET APPAREIL DE DETECTION DE L'HUMIDITE

(30) Priority: 31.07.1992 GB 9216308
(43) Date of publication of application: 17.05.1995
(73) Proprietor: PROTIMETER PLC, Marlow, Buckinghamshire SL7 1LX (GB)
(72) Inventor: DADACHANJI, Fali, Minocher 32 Highfield Park, Buckinghamshire SL7 2DE (GB)
(74) Representative: Lesley, Sheila F.
(86) International application number: GB9301475
(87) International publication number: WO9403817

(56) References cited:
- GB-A- 2 238 622
- US-A- 4 422 035
- US-A- 4 468 610
- RGE REVUE GENERALE DE L'ELECTRICITE no. 11, December 1991, PARIS,FR pages 36 - 40 , XP000273407 PERRIN 'LES MESURES EN CHAMPS LIBRE'
- "The Professionals and Home Owners Guide to Dampness in Buildings" by T.A. Oxley and E.G. Gobert (1983) published by Butterworths

## Description

This invention relates to an improved method of and device for measuring the moisture content of a material.

It is well known that a measure of moisture in materials can be obtained by measuring the electrical properties of the material, namely electrical resistance, capacitance, radio frequency (rf) admittance or impedance, etc. In the case of resistance measurement usually two pins, used as electrodes, are pushed into materials like wood, plaster and other porous building materials or, indeed, materials such as those used for building boats like GRP laminate. A disadvantage of the last-noted arrangement is that pin holes are left behind after measurement.

Another type of instrument used for measuring moisture control of materials uses rf capacitance measurement. Usually an instrument of this type utilises two electrodes mounted on a flat surface. The electrodes have a radio frequency oscillator connected to them and the near-field capacitance is measured. Higher moisture contents showing higher capacitance readings and *vice versa.*
This technique has a number of disadvantages as follows:
a) a relatively large area needs to be presented to the surface and to be in good contact with it for reliable measurements. Rough surfaces cause measurement problems;
b) as the measurement is made between flat electrodes on the same plane any "skin" moisture close to the electrodes will have a predominant effect on the measurement. Thus, a laminate several millimetres thick with condensate or other water film on the face will show an extremely high reading which is not a true indication of the total water content of the laminate.

Instruments of the above-noted types, and their uses, are discussed in the publication "The Professionals and Home Owners Guide to Dampness in Buildings" by T.A. Oxley and E.G. Gobert (1983) published by Butterworths.

US-A-4468610 discloses apparatus for measuring the moisture content of test pieces of gypsum board in which the capacitative impedance to a radio-frequency signal presented by an antenna disposed adjacent such a test piece is measured to provide an indication of the moisture content of the test piece.

It is an object of the invention to provide a novel method and apparatus for measuring moisture content which overcomes the above-noted problems of known instruments.

According to one aspect of the invention, there is provided a method of measuring the moisture content of a mass of material, comprising providing antenna means, arranging said antenna means in a predetermined position relative to a surface of said mass and measuring the radio frequency impedance of said antenna means, characterised in that said antenna means is constituted by a first and a second electrode, said first electrode being disposed at a location at or adjacent said surface of said mass and said second electrode being disposed at a location remote from said first electrode and from said mass, and in that said impedance measured is the free-field radio frequency impedance between said first and second electrodes.

According to another aspect of the invention, there is provided a device for measuring the moisture content of a material, the device comprising antenna means, means for applying a radio-frequency voltage signal to said antenna means, and means for measuring the radio-frequency impedance of said antenna means, characterised in that said antenna means is constituted by a first and a second electrode, said means for applying radio frequency voltage is arranged to apply said voltage between said electrodes; and said means for measuring is arranged to measure the free-field radio frequency impedance between said electrodes and in that said device comprises an elongate body having said first electrode at one end of said body and said second electrode at a position in said body spaced from said one end and from said first electrode.

An embodiment of the invention is described below by way of example with reference to the accompanying drawings, wherein:
FIGURE 1 is a diagrammatic side perspective view, in phantom, of a device embodying the invention;
FIGURE 2 is a graph showing, for comparison, the response of a known rf moisture measuring device and a device embodying the invention, in particular test conditions; and
FIGURE 3 shows in perspective, from two different aspects, a moisture measuring device embodying the invention.

Referring to the drawings, the device comprises an elongate body 10 defined by a plastics casing having mounted within it adjacent one end, a first electrode A and further having mounted within it, adjacent the flat lower wall of the casing, a second electrode B, which may, for example, take the form of a flat metal sheet or foil. The electrodes A and B are connected with circuitry (not shown) within the casing, for applying a radio frequency voltage between the electrodes A and B, the electrodes being otherwise electrically isolated from one another. The circuitry within the casing is also arranged to drive a display 12 (such as a galvanometer or a LCD display) and to provide via said display, a visual indication of the rf impedance between the electrodes A and B.

When the instrument is switched ON, with the instrument spaced substantially from any electrically conductive material, the radio frequency field emanating from the front end of the instrument (i.e. the end at which electrode A is disposed) is normally very weakly coupled to the electrode B in the body of the instrument and no reading is obtained. To test for moisture in a mass of material, for example a mass of solid material having a flat surface, the front end of the instrument is placed against that surface with the longest dimension of the body 10 extending substantially normal to such surface so that the electrode B is spaced substantially from that surface. Where the mass of material providing such surface is a dry electrically insulating material, the electrode A is again very weakly coupled with electrode B so that again no reading is obtained with the device switched on. However, when the device is placed, in a similar manner, against the surface of a mass of material which may in itself be non-conductive, but which has some moisture present within it, the water within the material acts to transmit the radio frequency signal allowing the moisture-containing material to act as an emitting aerial re-radiating the rf field to the electrode B in the lower half of the instrument, normally through the body 10. No part of the electrodes A or B or indeed any part of the electronic circuitry is in direct electrical contact with the material being tested. The "coupling" between the electrodes and the moisture-containing material is entirely made through radio frequency transmissions capable of passing through electrically insulating materials like plastic. This mode of measurement predominantly measures the mass of water in front of the instrument which in certain circumstances is a decided advantage.

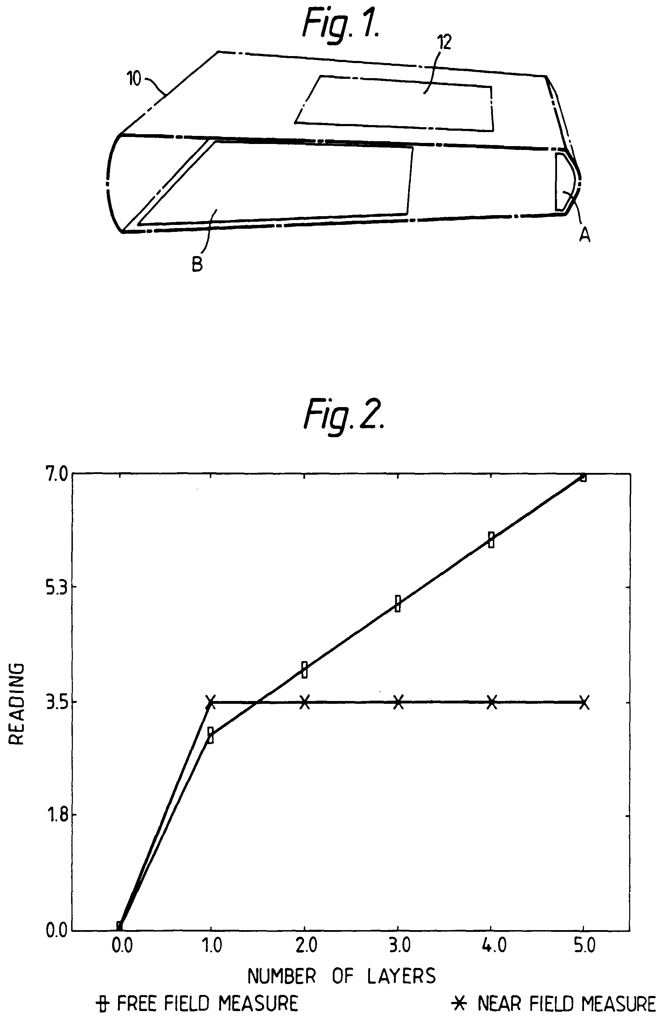

Figure 2 shows a comparative reading of several layers of wet film interleaved with an insulation material such as a film of pvc. In Figure 2, the quantity plotted along the Y-axis is admittance (i.e. the reciprocal of impedance), whilst the number of layers is plotted along the X-axis. It will be seen that using the conventional two electrode near-field measurement the first film shows a high reading but that subsequent further films do not add to the reading. In the case of the radio frequency free-field admittance measurement using the apparatus described with reference to Figure 1, the reading increases with every extra thickness of wet film. This makes the instrument much more useful for determining the total mass of water through a laminated material disregarding surface layers which may be damp from condensation or rainfall.

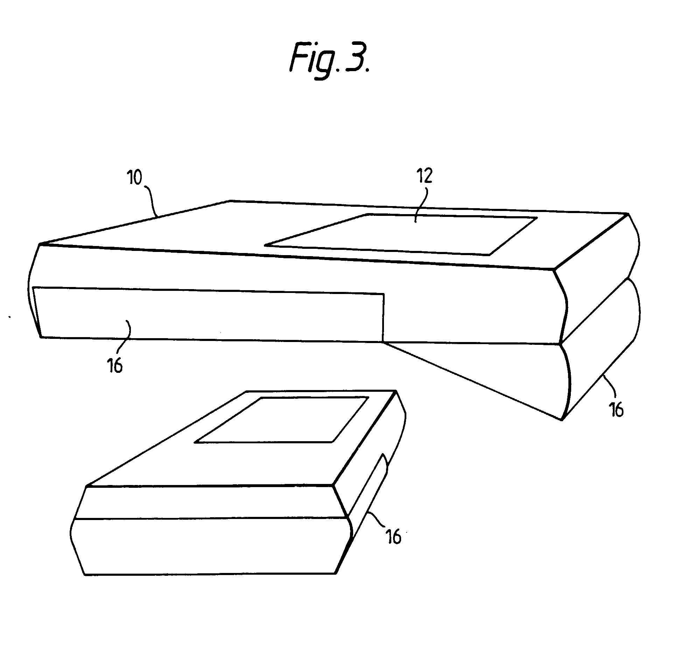

However, sometimes it is an advantage to be able to measure surface conditions predominantly. This can also be achieved with the same instrument, by using an additional clip-on transfer electrode as shown in Figure 3. The transfer electrode, indicated at 16 in Figure 3, when fitted, provides, at the front end of the device, below the rounded or bevelled front end of the casing proper, a second, similarly rounded or bevelled forwardly facing surface whereby, when the front end of the instrument fitted with the transfer electrode is held against a flat surface of material to be tested, the rounded or bevelled front end of the casing proper can make substantially line contact with said surface along a first line and the rounded or bevelled forwardly facing surface of the transfer electrode can make substantially line contact with said surface along a parallel line below the first line. The term "transfer electrode" is applied for convenience to the item 16 in its entirety, but it will be appreciated that it is unnecessary for the item 16 to be electrically conductive in its entirety. Indeed, it is envisaged that the item 16 will comprise a plastics outer shell with electrically conductive foil extending over the surface which, when the item 16 is fitted lies immediately below the lower wall of casing 10, below the electrode B, such foil extending, within the shell at least to the location directly behind the peak or ridge of the bevelled front part of such shell which is to engage the surface to be tested. Thus, because of the close proximity between the foil and the electrode B and the relatively large area of overlap with electrode B, there is very close coupling between the foil and the electrode B, so that the foil effectively forms an extension of the electrode B terminating at the front of the device. It will be understood that the arrangement is such that, with the transfer electrode 16 fitted, there is a sufficient dielectric gap, between the electrode A and the conductive foil at the front end of the shell, for the rf coupling between such foil and the electrode A to be negligible when the front ends of the device and electrode 16 are not engaged with the surface of a body of damp or otherwise electrically conductive material. Thus with the transfer electrode fitted, the base of the instrument is now electrically rf coupled to the active area adjacent to the normal working tip of the instrument. The double-ended instrument now acts as a near-field measurement device which is inherently more sensitive to water layers close to the sensing elements.

The preferred embodiment of the device thus comprises a single instrument which can normally measure moisture deep within a structure using the rf free-field technique but which, by fitting the transfer electrode described above, can also be used to make near-field surface measurements.

Whilst, as indicated, the devices described with reference to the drawings measure the free-field impedance between the electrodes, in general it will be preferably for the display 12 to be calibrated in terms of moisture content.

## Claims

1. A method of measuring the moisture content of a mass of material, comprising providing antenna means, arranging said antenna means in a predetermined position relative to a surface of said mass and measuring the radio frequency impedance of said antenna means, characterised in that said antenna means is constituted by a first (A) and a second (B) electrode, said first electrode (A) being disposed at a location at or adjacent said surface of said mass and said second electrode being disposed at a location remote from said first electrode and from said mass, and in that said impedance measured is the free-field radio frequency impedance between said first and second electrodes.

2. A device for measuring the moisture content of a material, the device comprising antenna means, means for applying a radio-frequency voltage signal to said antenna means, and means for measuring the radio-frequency impedance of said antenna means, characterised in that said antenna means is constituted by a first (A) and a second (B) electrode, said means for applying radio frequency voltage is arranged to apply said voltage between said electrodes (A, B) and said means for measuring is arranged to measure the free-field radio frequency impedance between said electrodes and in that said device comprises an elongate body (10) having said first electrode (A) at one end of said body (10) and said second electrode (B) at a position in said body (10) spaced from said one end and from said first electrode (A).

3. The device of claim 2 wherein said body (10) comprises a plastics casing, said first electrode (A) being mounted within the casing at one end of the casing, said second electrode (B) being mounted within the casing at a position spaced substantially from said one end and from said first electrode (A).

4. The device of claim 3 wherein said second electrode (B) is mounted adjacent a flat lower wall of said casing.

5. The device of claim 3 wherein said second electrode (B) comprises a flat metal sheet or foil disposed adjacent said flat lower wall of the casing.

6. A device according to claim 2 in combination with a detachable and re-attachable transfer electrode (16), wherein said transfer electrode, when fitted, extends from the vicinity of said second electrode (B) to said one end of said body, said transfer electrode (16) incorporating an electrically conductive element which terminates at the front of said body at a location adjacent to said first electrode but spaced laterally therefrom by a dielectric gap, the arrangement being such that when said transfer electrode is fitted, a low rf impedance path is established between said second electrode and said electrically conductive element.

## Patentansprüche

1. Verfahren zum Messen des Feuchtigkeitsgehalts einer Materialmasse, umfassend Bereitstellen eines Antennenmittels, Anordnen besagten Antennenmittels in einer vorherbestimmten Position relativ zu einer Fläche besagter Masse und Messen der Radiofrequenzimpedanz besagten Antennenmittels, dadurch gekennzeichnet, daß besagtes Antennenmittel aus einer ersten Elektrode (A) und einer zweiten Elektrode (B) aufgebaut ist, wobei besagte erste Elektrode (A) an einer Stelle an oder benachbart zu besagter Fläche besagter Masse angeordnet ist und besagte zweite Elektrode an einer Stelle entfernt von besagter ersten Elektrode und von besagter Masse angeordnet ist, und daß besagte gemessene Impedanz die Freifeldradiofrequenzimpedanz zwischen besagter ersten Elektrode und besagter zweiten Elektrode ist.

2. Vorrichtung zum Messen des Feuchtigkeitsgehalts eines Materials, wobei die Vorrichtung ein Antennenmittel, ein Mittel zum Anlegen eines Radiofrequenzspannungssignals an besagtes Antennenmittel und ein Mittel zum Messen der Radiofrequenzimpedanz besagten Antennenmittel umfaßt, dadurch gekennzeichnet. das das Antennenmittel von einer ersten Elektrode (A) und einer zweiten Elektrode (B) aufgebaut ist, daß besagtes Mittel zum Anlegen einer Radiofrequenzspannung angeordnet ist, um besagte Spannung zwischen besagten Elektroden (A, B) anzulegen, und daß besagtes Mittel zum Messen angeordnet ist, um die Freifeldradiofrequenzimpedanz zwischen besagten Elektroden zu messen, und daß besagte Vorrichtung einen länglichen Körper (10) umfaßt, der besagte erste Elektrode (A) an einem Ende besagten Körpers (10) und besagte zweite Elektrode (B) an einer Position in besagtem Körper (10) räumlich getrennt von besagtem einen Ende und von besagter ersten Elektrode (A) aufweist.

3. Vorrichtung nach Anspruch 2, dadurch gekennzeichnet, daß besagter Körper (10) ein Kunststoffgehäuse umfaßt, wobei besagte erste Elektrode (A) innerhalb des Gehäuses an einem Ende des Gehäuses angebracht ist, besagte zweite Elektrode (B) innerhalb des Gehäuses an einer Position räumlich im wesentlichen von besagtem ersten Ende und von besagter ersten Elektrode (A) getrennt angeordnet ist.

4. Vorrichtung nach Anspruch 3, dadurch gekennzeichnet, daß besagte zweite Elektrode (B) benachbart einer flachen unteren Wand besagten Gehäuses angebracht ist.

5. Vorrichtung nach Anspruch 3, dadurch gekennzeichnet, daß besagte zweite Elektrode (B) eine flache Metallage oder -folie umfaßt, die benachbart besagter flachen unteren Wand des Gehäuses angeordnet ist.

6. Vorrichtung nach Anspruch 2 in Kombination mit einer abnehmbaren und wiederanbringbaren Transferelektrode (16), wobei besagte Transferelektrode, wenn angepaßt, sich von der Nähe besagter zweiten Elektrode (B) zu besagtem einen Ende besagten Körpers erstreckt, wobei besagte Transferelektrode (16) ein elektrisch leitendes Element enthält, das an der Vorderwand besagten Körpers an einer Stelle benachbart zu besagter ersten Elektrode jedoch seitlich räumlich von derselben durch einen dielektrischen Zwischenraum getrennt endet, wobei die Anordnung so ist, daß, wenn besagte Transferelektrode angepaßt ist, ein Niedrigradiofrequenzimpedanzweg zwischen besagter zweiten Elektrode und besagtem elektrisch leitenden Element aufgebaut ist.

## Revendications

1. Procédé de mesure de la teneur en humidité d'une masse de matière comprenant la préparation d'un moyen d'antenne, la disposition dudit moyen d'antenne dans une position prédéterminée par rapport à une surface de ladite masse, et la mesure de l'impédance à radiofréquence dudit moyen d'antenne, caractérisé en ce que ledit moyen d'antenne comprend une première (A) et une seconde (B) électrodes, ladite première électrode (A) étant disposée en un emplacement se trouvant sur, ou adjacent à ladite surface de ladite masse, et ladite seconde électrode (B) étant disposée en un emplacement éloigné de ladite première électrode et de ladite masse, et en ce que ladite impédance mesurée est l'impédance à radiofréquence de l'espace libre entre lesdites première et seconde électrodes.

2. Dispositif pour la mesure de la teneur en humidité d'une matière, le dispositif comprenant un moyen d'antenne, un moyen pour appliquer un signal de tension à radiofréquence audit moyen d'antenne, et un moyen pour mesurer l'impédance à radiofréquence dudit moyen d'antenne, caractérisé en ce que ledit moyen d'antenne comprend une première (A) et une seconde (B) électrodes, ledit moyen pour appliquer une tension à radiofréquence est agencé pour appliquer ladite tension entre lesdites électrodes (A), (B), et ledit moyen de mesure est agencé pour mesurer l'impédance à radiofréquence de l'espace libre entre lesdites électrodes, et en ce que ledit dispositif comprend un élément allongé (10) ayant ladite première électrode (A) à une extrémité dudit élément (10), et ladite seconde électrode (B) en une position dudit élément (10) espacée de ladite première extrémité et de ladite première électrode (A).

3. Dispositif selon la revendication 2, dans lequel ledit élément (10) comprend un boîtier en matière plastique, ladite première électrode (A) étant montée à l'intérieur du boîtier à une extrémité de ce dernier, ladite seconde électrode (B) étant montée à l'intérieur du boîtier en une position espacée sensiblement de ladite première extrémité et de ladite première électrode (A).

4. Dispositif selon la revendication 3, dans lequel ladite seconde électrode (B) est montée adjacente à une paroi inférieure plane dudit boîtier.

5. Dispositif selon la revendication 3, dans lequel ladite seconde électrode (B) comprend une tôle ou une plaque métallique plane disposée adjacente à ladite paroi inférieure plane du boîtier.

6. Dispositif selon la revendication 2, associé avec une électrode de transfert (16), amovible et apte à être à nouveau fixée, dans lequel ladite électrode de transfert, une fois installée, s'étend depuis le voisinage de ladite seconde électrode (B) jusqu'à ladite première électrode dudit boîtier, ladite électrode de transfert (16) incorporant un élément électriquement conducteur qui se termine en avant dudit boîtier, en un emplacement adjacent à ladite première électrode, mais espacé latéralement de cette électrode par un espace diélectrique, l'agencement étant tel qu'au moment où ladite électrode de transfert est installée, un passage de faible impédance en RF est établi entre ladite seconde électrode et ledit élément électriquement conducteur.
